# EUROPEAN PATENT APPLICATION

(11) **EP 4 391 075 A2**
(43) Date of publication of application: **26.06.2024**
(21) Application number: 23211703.6
(22) Date of filing: 23.11.2023
(51) Int. Cl.: H01L 29/423, H01L 29/78, H01L 21/336

(54) **NONLINEAR GATE VERTICAL TRANSISTOR**

(30) Priority: 22.12.2022 EP 22216008
(71) Applicant: Nexperia B.V., 6534 AB Nijmegen (NL)
(72) Inventor: Pandey, Deepak Chandra, Manchester (GB); Hsu, Chih-Wei, Manchester (GB)
(74) Representative: Pjanovic, Ilija

(57) **Abstract**

A trench transistor with nonlinear gate-oxide-semiconductor boundary layout, and method of manufacture. The trench transistor comprises a gate region, an oxide region adjacent to the gate region, and a semiconductor region adjacent to the oxide region. The semiconductor region comprises a channel region along a gate-oxide-semiconductor boundary. The channel region configured to conduct current along the gate-oxide-semiconductor boundary when the transistor is turned on. The gate-oxide-semiconductor boundary has a nonlinear shape.

## Description

### FIELD

The present disclosure relates to a trench transistor, and a method of manufacturing thereof. In particular, it relates to trench metal-oxide-semiconductor field effect transistors in which the gate region has a nonlinear boundary adjacent to a channel region of the transistor.

### BACKGROUND

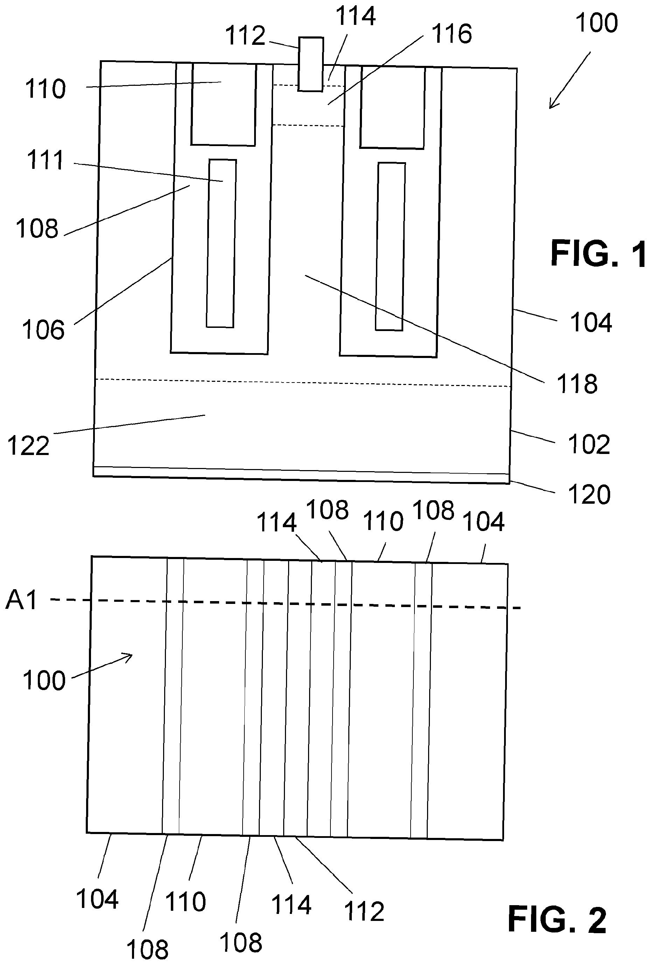

Trench transistors, such as trench metal-oxide-semiconductor field effect transistors (MOSFETs), are a known type **of** transistor. An example of a known trench MOSFET 100 is illustrated in figure 1. Trench MOSFETs are described for example in *"*Trench Gate Power MOSFET: Recent Advances and Innovations" (Raghvendra Sahai et al.) in Advances in Microelectronics and Photonics (2012). Transistor 100 comprises a semiconductor substrate 102 of a first conductivity type, and an epitaxial layer 104 of a first conductivity type arranged on semiconductor substrate 102. A trench region 106 is formed in epitaxial layer 104. The trench region 106 is covered on an inside thereof with an oxide layer 108 and is filled with one or more materials forming a gate 110. A further material 111 may be present in the trench region 106. The material 111 may be for example polysilicon or any other suitable material. Material 111 may be connected to the source electrode.

A source region 114 of a first conductivity type and a body region 116 (also referred to as channel body region) of a second conductivity type are further formed in epitaxial layer 104. The second conductivity (e.g. p-type) type may be different from the first conductivity type (e.g. n-type). Epitaxial layer 104 comprises a drift region 118 of the first conductivity type arranged in between body region 116 and substrate 102. Source region 114 and body region 116 may be formed adjacent to trenches, e.g. in between neighbouring trenches. Body region 116 is arranged in between source region 114 and drift region 118. Below the drift region 118, a drain region 122 of the transistor may be provided on substrate 102. An electrical contact 112 may be added to contact the source region 114 and body region 116 of the transistor 100. A further electrical contact 120 may be added to provide a contact to the drain region of the transistor 100. The trench transistor of figure 1 may be referred to as a trench vertical transistor, as the drain region 122 is provided below the drift region 118. A trench transistor design in which the source region and drain region are both provided on top (at the same side) of the trench region is also possible.

Trench transistors may be used for many different applications. Regardless of the application, it may be desirable for a transistor to be as efficient as possible, so that energy consumption to operate the transistor within the context of its application may be reduced. This may for example be achieved by reducing the resistance of the transistor. Elements contributing to the resistance of the transistor include (but are not limited to) the channel body region 116, and the drift region 118. As technology has advanced, scaling down of the channel body resistance has been a challenge for current trench transistors. This means that the contribution of the channel body 116 resistance may be significant, especially in low voltage applications (e.g. voltages of 80V or below). transistor layouts and fabrication methods for reducing the resistance of channel body regions of trench transistors are provided herein.

### SUMMARY

According to a first aspect of the present disclosure there is provided a trench transistor, comprising a gate region, an oxide region adjacent to the gate region, and a semiconductor region adjacent to the oxide region. The semiconductor region comprises a channel region along a gate-oxide-semiconductor boundary. The channel region is configured to conduct current along the gate-oxide-semiconductor boundary when the transistor is turned on. The gate-oxide-semiconductor boundary has a nonlinear shape. Although referred to herein as a gate-oxide-semiconductor boundary, one or more other layers may be present in between the gate region, oxide region, and semiconductor region. The conductive channel may be formed in the semiconductor region along the boundary of the semiconductor region and the material closest to the semiconductor region (e.g. the gate region).

Optionally, the nonlinear shape may comprise a piecewise linear shape.

Optionally, the piecewise linear shape may comprise a periodic rectangular shape.

Optionally, the oxide region may be immediately adjacent to the gate region.

Optionally, the semiconductor region may be immediately adjacent to the oxide region.

Optionally, the trench transistor may be a trench gate power metal-oxide-semiconductor field effect transistor.

Optionally, the semiconductor region may be an epitaxial region.

Optionally, the trench transistor may be a trench vertical transistor.

According to another aspect of the present disclosure there is provided a method of manufacture for a nonlinear vertical transistor gate. The method comprises providing a vertical transistor manufacturing intermediate having a vertical gate region and oxide region. A recess is etched along a portion of a vertical dimension of the vertical gate region and the oxide region. A photoresist layer is deposited. A gate mask is developed in the photoresist layer, wherein the gate mask has a nonlinear shape. The nonlinear gate is patterned using the gate mask, thereby providing a nonlinear shape for providing the nonlinear vertical transistor gate.

According to another aspect of the present disclosure there is provided a method of manufacture of a nonlinear vertical transistor gate. The method comprises providing a vertical transistor manufacturing intermediate having a vertical gate region and an oxide region. A recess is etched along a portion of a vertical dimension of the vertical gate region and the oxide region. A photoresist layer is deposited. A mask is developed in the photoresist layer such that the mask covers a first portion of the gate recess and exposes a second portion of the gate recess. The exposed second portion of the recess is isotropically etched, while the first portion of the recess is protected, thereby providing a nonlinear shape for providing the nonlinear vertical transistor gate.

According to another aspect of the present disclosure there is provided a method of manufacture for a trench transistor as described above, having a nonlinear vertical transistor gate manufactured using a method as described above.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 depicts a schematic representation of a cross-sectional view along of a trench transistor;
- Figure 2 depicts a schematic representation of a top view of a trench transistor;
- Figure 3 depicts a schematic representation of a top view of a trench transistor with a nonlinear gate;
- Figures 4A and 4B depict a schematic representation of a cross-sectional view along a cross-section of a trench transistor with a nonlinear gate;
- Figure 5 depicts a flowchart of a method of manufacture of a nonlinear vertical transistor gate for a trench transistor; and
- Figure 6 depicts a flowchart of a method of manufacture of a nonlinear vertical transistor gate for a trench transistor.

### DETAILED DESCRIPTION

Trench transistors, which may also be referred to as trench MOSFETs, trench gate power transistors, or power transistors, are a type of transistor in which the current flowing through the transistor moves at least in part along a trench that is created in a substrate. This may for example comprise current flowing vertically through layers on a substrate (in which the plane of the substrate is referred to as horizontal). As described in the background section above, figure 1 schematically depicts a trench vertical transistor 100.

Figure 2 depicts a schematic top view of a trench transistor 100. Figure 1 may be a cross-section along a portion of line A1 of figure 2. The top view of figure 2 may be referred to as being in (parallel to) the plane of the substrate. This plane of the substrate may be referred to as the horizontal plane. A direction perpendicular to the plane of the substrate (i.e. going into the page for figure 2) may be referred to as the vertical dimension/direction. Gate material 110 (and material 111) may be flanked on both sides by insulator layers and/or gate oxide layers 108. A semiconductor layer (e.g. epitaxial layer) with source region 114 on top may be provided around the gate and oxide regions. An electrical contact layer 112 may be provided on the semiconductor layer 104, acting as a source contact. As shown in figure 2, the trenches comprising the gate, insulator and/or oxide regions are laid straight (linear). The shape of the gate follows the shape of the trench. The trench runs straight along an entire dimension of the transistor, in the plane of the substrate. This dimension of the transistor may be referred to as the width of the transistor. The top view of figure 2 does not have to be the top layer of a finalised transistor and/or integrated device, and one or more other layers may be deposited on top of the layer(s) viewed in figure 2.

In a vertical transistor, when the transistor is turned on, current may flow along a substantially vertical direction, from source region 114 to drain region 122. The current may flow through a body region 116, in which a conducting channel is created when the gate is turned on. The channel may be created along a gate-oxide-semiconductor (which may specifically be along the oxide-semiconductor portion of the boundary) boundary inside the body region 116. As mentioned above, a challenge with existing vertical transistors may be the high channel resistance of the transistor, and the negative effects this may have on the efficiency of the transistor.

In this disclosure, a transistor layout that reduces the resistance of the body region is proposed. It is provided herein that the overall resistance of the channel of a trench transistor can be reduced by increasing the channel width (the size of the channel in the plane of the substrate). As the channel is formed along a semiconductor and gate-oxide boundary, the length of this boundary may determine the width of the conductive channel. In figure 2, the length of the gate-oxide-semiconductor boundary along which the channel may be formed is along a straight line inside the plane of the substrate (i.e. a linear shape). This boundary length may be increased by increasing the size of the transistor along the width in the substrate plane. However, this increased transistor size is undesirable, and may have other negative effects on performance and cost. Proposed herein is to increase the length of the boundary while keeping the die-size (i.e. die-area) the same by providing a non-linear gate shape, so that the length of gate-oxide-semiconductor boundary can be increased while the area taken up by the transistor in the substrate plane remains the same.

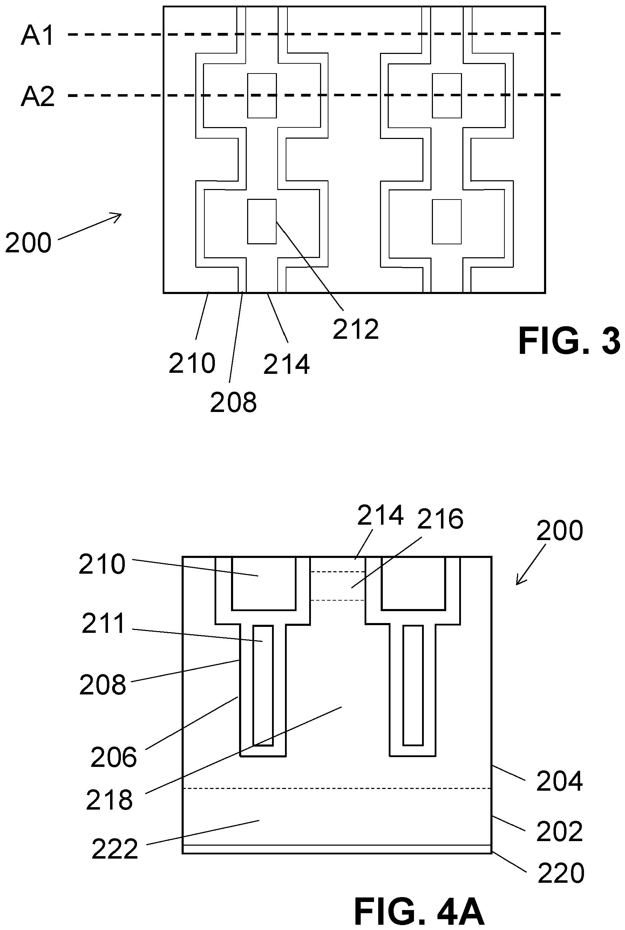

Figure 3 depicts a schematic representation of a top view of a trench transistor 200 with a gate-oxide-semiconductor boundary having a nonlinear shape. The trench transistor 200 may be a trench vertical transistor. A gate region 210 having a nonlinear shape is provided. An oxide region 208 is provided adjacent to the gate region 210. The oxide region 208 adopts the nonlinear shape of the gate 210. A semiconductor region 204 with source region 214 on top may be provided adjacent to the oxide region 208, in which a source region and a body region are present. The gate region 210 may be immediately adjacent to the oxide region 208. The oxide region 208 may be immediately adjacent to the semiconductor region 204. The source region 214 and underlying body region 216 and semiconductor region 204 may adopt a nonlinear shape of the adjacent gate region 210 and oxide region 208. An electrical contact 212 may be provided on the source region 214. The result is a trench vertical transistor with a nonlinear gate-oxide-semiconductor boundary.

An advantage of this nonlinear layout is that it may result in a longer gate-oxide-semiconductor boundary compared to a straight gate shape. As the channel region for conducting current through the transistor is formed along this boundary, it means that the overall width of the channel is increased. This has an advantage of reducing the overall resistance of the channel body and therefore may lead to improved performance of the transistor. Although the nonlinear boundary is described here in relation to a gate-oxide-semiconductor boundary, the skilled person would understand that other layer configurations (e.g. comprising one or more additional or different layers) may be provided in the nonlinear boundary configuration.

Figure 4A depicts a schematic representation of a trench transistor in a vertical dimension perpendicular to the plane of the substrate. The transistor may be a trench vertical transistor. The depicted vertical dimension may for example be a cross-section of a transistor 200 of figure 3 along a portion of line A1. A substrate 202 is provided. An semiconductor layer, which may be an epitaxial layer 204 of a first conductivity type is arranged on substrate 202. A trench region 206 may be formed in epitaxial layer 204. The trench region 206 is covered on an inside thereof with an oxide layer 208 and is filled with a gate material 210. A portion of trench region may also be filled with material 211, which may be connected to a source electrode. Gate material 210 and material 211 may be electrically isolated from each other. A source region 214 of a first conductivity type and a body region 216 of a second conductivity type are further formed in semiconductor layer 204. Semiconductor layer 204 comprises a drift region 218 of the first conductivity type arranged in between body region 216 and substrate 202. Source region 214 and body region 216 may be formed adjacent to a trench, e.g. in between neighbouring trenches. Body region 216 may be arranged in between source region 214 and drift region 218. A drain region 222 may be provided below drift region 218 on substrate 202.

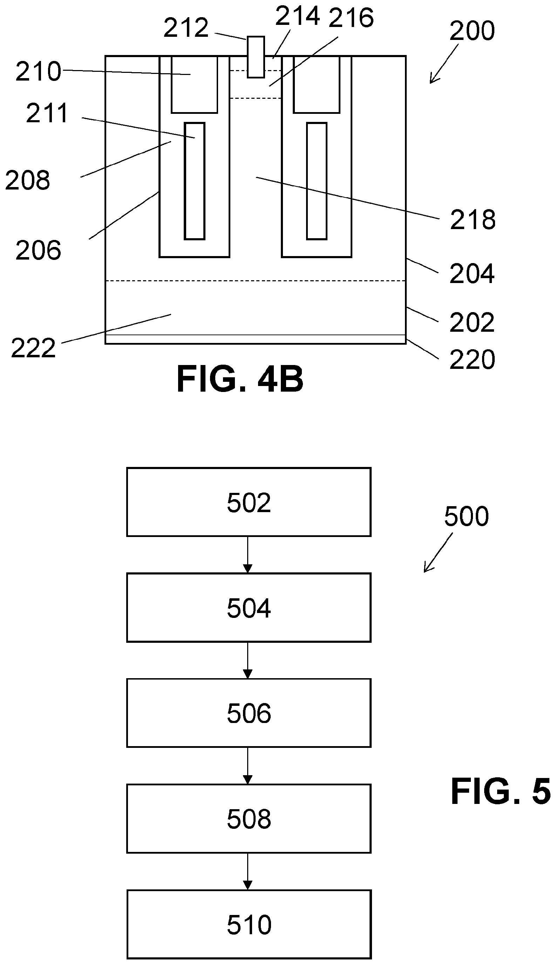

Figure 4B depicts a schematic representation of a trench transistor in a vertical dimension perpendicular to the plane of the substrate. It may for example be a cross-section of a transistor 200 of figure 3 along a portion of line A2. Transistor 200 may be a trench vertical transistor. Features of figure 4B may be as described for figure 4A above. Comparing cross-sections of figures 4A and 4B, the size of at least a portion of the gate region 210 in figure 4A may be wider than the size of the corresponding (portion of) the gate region in figure 4B. This may be a result of the nonlinear gate shape and associated nonlinear gate-oxide-semiconductor boundary.

Electrical contacts 212 and/or 220 may be added to the transistor 200 for connecting to the source regions 214 and drain regions 222, respectively. Electrical contacts may be added across all of or a portion of the length of the substrate. For example, in areas where the nonlinear gate structure is wider, an electrical contact may be absent. A metallic layer may be provided underneath substrate 202 to act as electrical contact 220 for drain region 222.

The nonlinear gate-oxide-semiconductor boundary may comprise a piecewise linear shape. The piecewise linear shape may for example be a rectangular (e.g. square) periodic shape, for example as illustrated in figure 3. Other shapes, such as curved shapes, may be provided alternatively and/or additionally. In figures 3, 4A, and 4B, the nonlinear boundary shape may be achieved through a gate region 210 having a nonlinear shape, with an oxide region 208 having a substantially constant thickness along the nonlinear gate shape, thereby adopting a corresponding nonlinear shape adjacent to the gate region outline. The semiconductor region 204 may be formed around the nonlinear oxide shape to also obtain a nonlinear shape.

The gate material of gate region 210 may comprise one or more of polysilicon, tungsten, titanium nitride (TiN) and/or any other suitable metal. The gate oxide material of oxide region 208 may comprise one or more of silicon dioxide (SiO₂), hafniumdioxide (HfO₂), hafniumnitride (HfN), and/or any suitable dielectric material. The oxide layer may be thermally grown onto semiconductor region 204. The semiconductor region 204 in which the source region 214, body region 216, and drift region 218 are present may comprise one or more of silicon (Si), silicon carbide (SiC), gallium nitride (GaN), gallium(III) oxide (Ga₂O₃) or any other suitable material for a transistor. The semiconductor region 204 may be an epitaxially formed region. The epitaxial semiconductor region 204 may have a lower doping concentration than other regions such as the substrate 202. This may be so that the transistor can sustain a desired breakdown voltage.

The transistor may have different regions that are doped with different conductivity types/materials and at different doping concentrations. The first conductivity type may be n-type. The second conductivity type may be p-type. The first conductivity type may be different from the second conductivity type. In other implementations the first conductivity type may be p-type, and the second conductivity type may be n-type. The substrate may comprise a doped region of the first conductivity type, e.g. n-type, for example a phosphorous and/or arsenic doped silicon substrate. N-type conductivity regions (e.g. the source region) may for example comprise arsenic and/or phosphorus doped semiconductor (e.g. silicon). P-type conductivity regions (e.g. body region) may for example comprise boron doped semiconductor (e.g. silicon). The n-doped epitaxial region may be doped with phosphorous.

The trench transistors as described herein may have an operating voltage anywhere from 15V upwards, or 30V upwards. The effect of reducing resistance of the channel body may be particularly advantageous in applications for which a transistor has a low operating voltage (e.g. 80V or lower). The die-size on the substrate may be in a range of 2 mm by 2 mm and upwards. The pitch may be in a range of 0.6 µm and upwards. The trench width of a transistor trench may be in a range of 0.3 µm and upwards. The trench depth of a transistor trench may be in a range of 1 µm and upwards. The gate oxide layer may have a thickness in a range of 30 nm and upwards. The gate depth may be in a range of 0.5 µm and upwards. The thickness of the epitaxial semiconductor layer may be in a range of 0.6 µm and upwards. The drain-source on-resistance (R_{DSon}) may be in a range of 0.4 mΩ and upwards.

According to a further aspect of the disclosure there is provided a method for manufacturing a trench transistor having a nonlinear gate-oxide-semiconductor boundary as described above. Many of the fabrication steps for manufacturing the transistor are the same as for known trench transistors, and will therefore not be discussed in detail herein. The description of the method of manufacture will focus on steps for obtaining a nonlinear vertical trench gate, with associated nonlinear gate-oxide-semiconductor boundary.

Figure 5 depicts a flow chart of steps in a method 500 of manufacture of a nonlinear transistor gate. These steps may be implemented as part of a bigger method of manufacturing a trench transistor, such as a trench vertical transistor. In step 502, a vertical transistor manufacturing intermediate having a trench gate region and oxide region may be provided. A recess may be etched 504 along a portion of the vertical dimension of the trench gate and oxide regions. The depth of the recess may be substantially to the desired depth of the gate region. A further material 211 may be added to the recess, connected to a source electrode. The After the recess has been etched, a photoresist layer may be deposited 506. A mask may be patterned and developed 508 in the photoresist layer, such that the mask covers a first portion of the gate recess and exposes a second portion of the recess. Once the mask has been developed, an isotropic etch is performed 510, isotropically etching the exposed second portion of the recess, while the covered first portion of the recess is protected from etching by the mask. This etch, etching part of the gate recess, provides a nonlinear shape for providing the nonlinear transistor gate.

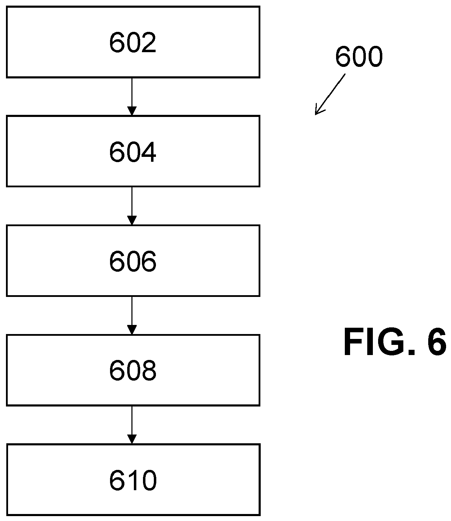

Figure 6 depicts a flow chart of steps in a method 600 of manufacture of a nonlinear vertical transistor gate. These steps may be implemented as part of a bigger method of manufacturing a trench transistor, such as a trench vertical transistor. In step 602, a trench transistor manufacturing intermediate having a trench gate region and oxide region may be provided. A recess may be etched 604 along a portion of the vertical dimension of the trench gate and oxide regions. After the recess has been etched, a photoresist layer may be deposited 606. A mask may be patterned and developed 608 in the photoresist layer, such that the mask has a nonlinear shape. Once the mask has been developed, the nonlinear gate may be patterned 610 using the gate mask. This may be such that the nonlinear gate has a shape corresponding to the nonlinear shape of the gate mask. Pattering the nonlinear gate may involve etching a nonlinearly shaped recess using the mask

Once the nonlinear shape of methods 500 and 600 has been achieved through etching using the photoresist mask, the developed photoresist mask may be stripped, and the nonlinear shaped recess may be filled with a gate oxide layer and gate material, respectively. This may achieve the nonlinear gate shape and associated nonlinear gate-oxide-semiconductor boundary that leads to reduced transistor body resistance. The manufacturing process may continue and be finalised using known manufacturing steps for trench transistors (e.g. manufacturing steps for adding electrical contacts).

A manufacturing intermediate mentioned above may be manufactured using known manufacturing steps for trench transistors. These may include for example providing a semiconductor substrate with an (epitaxial) semiconductor layer of a first conductivity type arranged thereon, and forming one or more trenches in the (epitaxial) semiconductor layer. In a next step c) a liner oxide layer may be deposited that covers an inside of the one or more trenches. Next, in step d), a gate material (e.g. polysilicon) may be provided, e.g. by deposition, in each of the one or more trenches. The resulting structure may be provided as the manufacturing intermediate of steps 502 and/or 602 above.

Although the description and figures provided are in relation to trench MOSFETs, the features and concepts described herein may also be provided correspondingly to other transistor technologies, for example insulated gate bipolar transistors.

## Claims

1. A trench transistor, comprising:
a gate region comprising a first gate material (110) and a second gate material (111)
an oxide region adjacent to the gate region;
a semiconductor region adjacent to the oxide region;
wherein the semiconductor region comprises a channel body region along a gate-oxide-semiconductor boundary, the channel body region configured to conduct current along the gate-oxide-semiconductor boundary when the transistor is turned on; and
wherein the gate-oxide-semiconductor boundary has a nonlinear shape.

2. A trench transistor according to claim 1, wherein the nonlinear shape comprises a piecewise linear shape.

3. A trench transistor according to claim 2, wherein the piecewise linear shape comprises a periodic rectangular shape.

4. A trench transistor according to any of the preceding claims, wherein the oxide region is immediately adjacent to the gate region.

5. A trench transistor according to any of the preceding claims, wherein the semiconductor region is immediately adjacent to the oxide region.

6. A trench transistor according to any of the preceding claims, wherein the trench transistor is a trench gate power metal-oxide-semiconductor field effect transistor.

7. A trench transistor according to any of the preceding claims, wherein the semiconductor region is an epitaxial region.

8. A trench transistor according to any of the preceding claims, wherein the trench transistor is a trench vertical transistor.

9. A method of manufacture of a nonlinear vertical transistor gate, comprising:
providing a vertical transistor manufacturing intermediate having a vertical gate region and an oxide region, the gate region comprising a first gate material (110) and a second gate material (111);
etching a recess along a portion of a vertical dimension of the vertical gate region and the oxide region;
depositing a photoresist layer;
developing a mask in the photoresist layer such that the mask covers a first portion of the gate recess and exposes a second portion of the gate recess; and
isotropically etching the exposed second portion of the recess, while the first portion of the recess is protected, thereby providing a nonlinear shape for providing the nonlinear vertical transistor gate.

10. A method of manufacture for a nonlinear vertical transistor comprising the steps according to any of claim 9 .
